# EUROPEAN PATENT APPLICATION

(11) **EP 1 575 337 A2**
(43) Date of publication of application: **14.09.2005**
(21) Application number: 05005048.3
(22) Date of filing: 08.03.2005
(51) Int. Cl.: H05B 33/04, H05B 33/14

(54) **Double-sided display device and method of fabricating the same**

(30) Priority: 10.03.2004 JP 2004067170
(71) Applicant: Tohoku Pioneer Corporation, Yamagata-ken (JP)
(72) Inventor: Tanaka, Shinsuke Yonezawa Koujou, Yonezawa-shi Yamagata-ken 992-1128 (JP)
(74) Representative: Sajda, Wolf E.

(57) **Abstract**

In a double-sided display device 1 including a pair of substrates 10A, 10B, self-emitting element areas 11A, 11B formed on the pair of substrates, respectively, the self-emitting elements being provided in a sealed space M formed by bonding the pair of substrates to each other, and display planes 1a, 1b each being formed on the bottom face side of each of the substrates so as to be oriented in the opposite directions, a desiccant 13 is provided in a space on at least one of the substrates within the sealed space. Thus, in the double-sided display device, the sealed space can be effectively used.

## Description

### BACKGROUND OF THE INVENTION

The present invention relates to a double-sided display device and a method of fabricating the same.

Various types of self-emitting flat panel display devices such as an organic electroluminescence (EL) display device, a plasma display panel (PDP), and a field emission display (FED) have recently been developed. In these display devices, a display section is formed by arranging self-emitting elements on a substrate. Therefore, the display devices have attracted attention as display devices which are advantageous over liquid crystal displays requiring a backlight in possibility of reduction of power consumption as well as of thickness.

Moreover, in the self-emitting flat panel display devices, substrates of two displays are bonded to each other so that their light-emitting sides are oriented outward. As a result, a double-sided display device enabling the display on both sides can be formed. In Japanese Patent Application Laid-Open No. Hei 8-153586, a double-sided display device formed by an organic EL display device is disclosed. In the case of the organic EL display device, a sealing structure for blocking organic EL elements formed on a substrate from the outside air is required because the organic EL element has a property of deteriorating its display performance when it is exposed to the outside air containing moisture and the like. According to the above-described conventional technique, a pair of substrates, each being a transparent substrate on which organic EL elements are formed, are bonded to each other so that their faces carrying the organic EL elements face each other. In this manner, the organic EL elements are sealed between the pair of substrates. A display plane is formed on the bottom face side of each of the substrates so that the display planes of the respective substrates are oriented in the opposite directions, thereby achieving the display on both sides.

In the double-sided display device including the self-emitting elements formed on the substrates as described above, the entire substrate is not necessarily used as a display plane. It often happens that the area of a display plane formed on one side of a double-sided display device differs from the area of a display plane formed on the other side, and that the position of a display plane formed on one side of a double-sided display device is not coincident with the position of a display plane formed on the other side, and the like. In such a case, according to the above-described conventional technique for sealing the organic EL elements between two substrates, a vacant space is formed on the substrate in the sealed space. Therefore, it is hardly considered that the double-sided display device effectively uses the space as a display panel unit required to occupy a smaller space.

Moreover, in the above-described conventional technique, the use of a moisture-proof agent in a sealing member (adhesive member) for bonding a pair of substrates is disclosed as means of moisture proof in the sealed space. However, it is difficult to effectively moisture-proof the entire sealed space for sealing self-emitting elements such as organic EL elements respectively formed on the pair of substrates by the moisture-proof agent in the sealing member. In particular, there arises a problem that the outgas entering from the sealing member into the sealed space upon or after curing of the sealed member cannot be effectively eliminated.

### SUMMARY OF THE INVENTION

The present invention has an object of coping with the above-described problems. Specifically, in a double-sided display device including a pair of substrates each including a self-emitting element area formed thereon, the substrate being bonded to each other so that each of the self-emitting element areas is provided within a sealed space formed by the bonding, the present invention has objects of effectively using the sealed space, effectively excluding the outgas entering the sealed space upon or after bonding of the pair of substrates, and the like.

In order to achieve the above object, a double-sided display device and a method of fabricating the same according to the present invention include at least a configuration according to each of the following independent aspects.

In a first aspect of the present invention, a double-sided display device comprises: a pair of substrates; self-emitting element areas formed on the pair of substrates, respectively, the self-emitting element areas being provided in a sealed space formed by bonding the pair of substrates to each other; and display planes each being formed on each bottom face of the substrates so as to be oriented in opposite directions, wherein a desiccant is provided in a space on at least one of the substrates within the sealed space.

In a second aspect of the present invention, a double-sided display device comprises: a pair of substrates; self-emitting element areas formed on the pair of substrates, respectively, the self-emitting element areas being provided in a sealed space formed by bonding the pair of substrates to each other; and display planes each being formed on each bottom face of the substrates so as to be oriented in opposite directions, wherein a driving circuit component is provided in a space on at least one of the substrates within the sealed space.

In a third aspect of the present invention, a method of fabricating a double-sided display device (the display device including: a pair of substrates; self-emitting element areas formed on the pair of substrates, respectively, the self-emitting elements being provided in a sealed space formed by bonding the pair of substrates to each other; and display planes each being formed on each bottom face of the substrates so as to be oriented in opposite directions) comprises the steps of: providing any one of a desiccant and a driving circuit component in a space on a face of at least one of the substrates, on which the self-emitting element area is formed, after formation of the self-emitting element areas on the respective substrates; and arranging the one of the desiccant and the driving circuit component in the sealed space formed by bonding the pair of substrates to each other.

### BRIEF DESCRIPTION OF THE DRAWINGS

These and other obj ects and advantages of the present invention will become clear from the following description with reference to the accompanying drawings, wherein:
Figs. 1A and 1B are explanatory views showing a structure of a double-sided display device according to an embodiment of the present invention, where Fig. 1A is a sectional view taken along the line I-I in Fig. 1B, and Fig. 1B is a plan view;
Figs. 2A to 2C are explanatory views showing a variation of the double-sided display device according to the embodiment of the present invention, where the arrangement or the shape of the display planes is changed, Fig. 2A being a sectional view taken along the line I-I in Fig. 2B, Fig. 2B being a plan view, and Fig. 2C being a rear view;
Figs. 3A to 3C are explanatory views showing another variation of the double-sided display device according to the embodiment of the present invention, where the arrangement or the shape of the display planes is changed, Fig. 3A being a sectional view taken along the line I-I in Fig. 3B, Fig. 3B being a plan view, and Fig. 3C being a rear view;
Figs. 4A to 4C are explanatory views showing a further variation of the double-sided display device according to the embodiment of the present invention, where the arrangement or the shape of the display planes is changed, Fig. 4A being a sectional view taken along the line I-I in Fig. 4B, Fig. 4B being a plan view, and Fig. 4C being a rear view;
Fig. 5 is an explanatory view showing an example of forming an engraved portion for providing a desiccant therein on the substrate of the double-sided display device according to the embodiment of the present invention;
Fig. 6 is an explanatory view showing another example of forming an engraved portion for providing a desiccant therein on the substrate of the double-sided display device according to the embodiment of the present invention;
Fig. 7 is an explanatory view (sectional view) showing a double-sided display device according to another embodiment of the present invention;
Fig. 8 is an explanatory view showing a method of fabricating the double-sided display device according to the embodiment of the present invention; and
Fig. 9 is an explanatory view (sectional view) showing an example of the present invention.

### DETAILED DESCRIPTION OF THE PREFERRED EMBODIMENTS

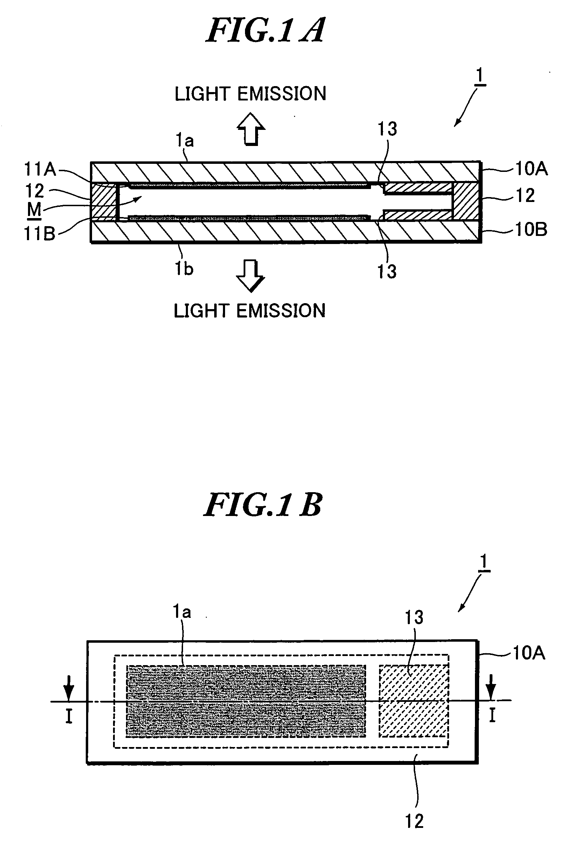

Hereinafter, an embodiment of the present invention will be described with reference to the accompanying drawings. Figs. 1A and 1B are explanatory views showing a structure of a double-sided display device according to an embodiment of the present invention (Fig. 1A is a sectional view taken along the line I-I in Fig. 1B, and Fig. 1B is a plan view). A double-sided display device 1 has the following structure. Self-emitting element areas 11A and 11B are formed on a pair of substrates 10A and 10B, respectively. Each of the self-emitting element areas 11A and 11B is provided in a sealed space M formed by bonding the pair of substrates 10A and 10B to each other. Then, display planes 1a and 1b are formed on the bottom face sides of the substrates 10A and 10B, respectively, so as to be oriented in the opposite directions.

Each of the substrates 10A and 10B is formed of a transparent orsemi-transparentsubstrate. The self-emitting element are as 11A and 11B respectively formed on the substrates 10A and 10B have a bottom-emission structure for emitting light toward the bottom face side through the substrates 10A and 10B. The substrates 10A and 10B are bonded to each other through a bonding layer 12 so as to form a sealed space M between the substrates 10A and 10B. In the sealed space M, the self-emitting element areas 11A and 11B are provided.

In the double-sided display device 1 having the above-described structure, the self-emitting element areas 11A and 11B are formed not on the entire surfaces of the substrates 10A and 10B in the sealed space M, respectively. Therefore, there exist spaces in the sealed space M where the self-emitting element areas 11A and 11B are not formed. In order to effectively use the spaces on the substrates 10A and 10B, desiccants 13 (herein, the desiccant encompasses all materials having the function of eliminating moisture or the like in the sealed space M) are provided in the spaces.

In the double-sided display device 1 according to the above-described embodiment, the display device is first formed by the pair of substrates 10A and 10B. Therefore, a solid display device can be formed. Moreover, since two self-emitting element areas 11A and 11B for realizing the display on both sides are formed in the single sealed space M, the space efficiency in a thickness direction is high. As a result, a thin display device can be formed.

Furthermore, when various arrangements or shapes (sizes) of the display planes 1a and 1b are used, the desiccants 13 can be provided by using vacant spaces formed in the sealed space M on the substrates 10A and 10B. Therefore, the space efficiency in a plane direction is also high. Accordingly, in combination with the above-described high space efficiency in the thickness direction, the reduction in the size of the display device can be made possible. Moreover, since the sufficient desiccants 13 can be provided within the sealed space M, the desiccants 13 can surely eliminate the outgas entering from the adhesive layer 21 or the like into the sealed space M upon or after bonding of the substrates 10A and 10B.

As a result, the double-sided display device 1, which can keep good display performance for a long period of time and also enables the reduction in size, can be provided. A variation of the arrangement or the shape of the display planes 1a and 1b can be appropriately determined in accordance with an intended application.

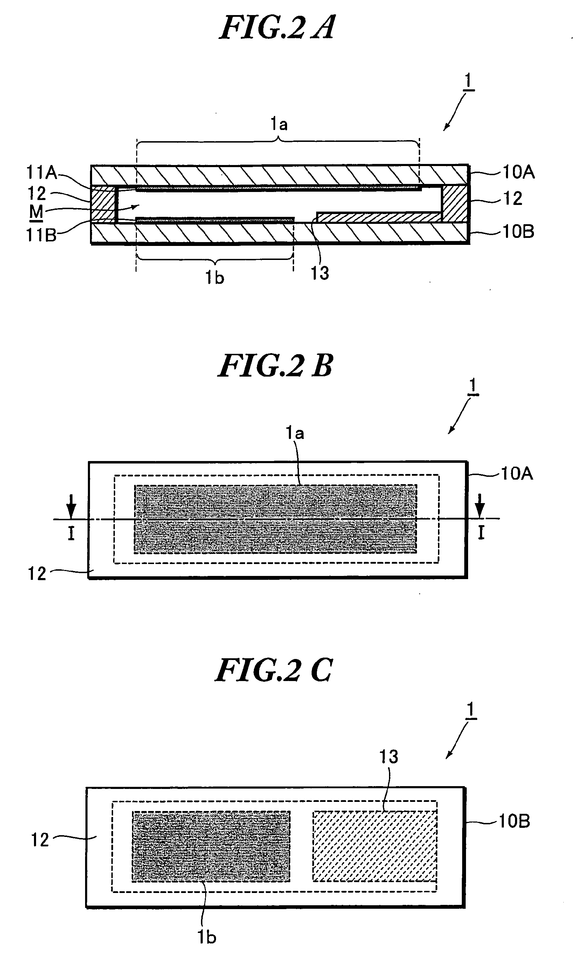

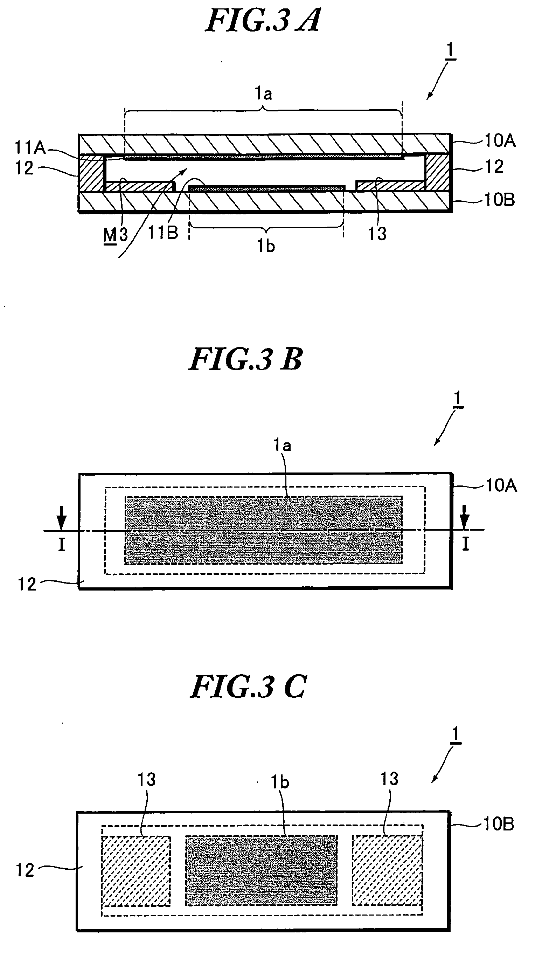

Figs. 2A to 2C, 3A to 3C, and 4A to 4C are illustrative view showing examples (variations) where the arrangement or the shape of the display planes 1a and 1b is changed in the double-sided display device 1 according to the embodiment of the present invention (Figs. 2A, 3A, and 4A are sectional views taken along the respective lines I-I in Figs. 2B, 3B, and 4B, respectively, Figs. 2B, 3B, and 4B are plan views, and Figs. 2C, 3C, and 4C are rear views). Hereinafter, the same sections as those in Fig. 1 are denoted by the same reference numerals, and part of description therefor will be omitted. In the examples shown in Figs. 2A to 2C and 3A to 3C, the area of the self-emitting element area 11A formed on one substrate 10A differs from that of the self-emitting element area 11B formed on the other substrate 10B. The desiccant 13 is provided on the substrate 10B, on which the self-emitting element area 11B having the smaller area is formed.

Specifically, the double-sided display device 1 according to this embodiment corresponds to the case where the display plane 1a on the substrate 10A side forms a larger main screen, whereas the display plane 1b on the substrate 10B side forms a smaller sub-screen. In such a case, since a vacant space is generated on the substrate 10B forming the sub-screen within the sealed space M, the desiccant 13 is provided using the vacant space.

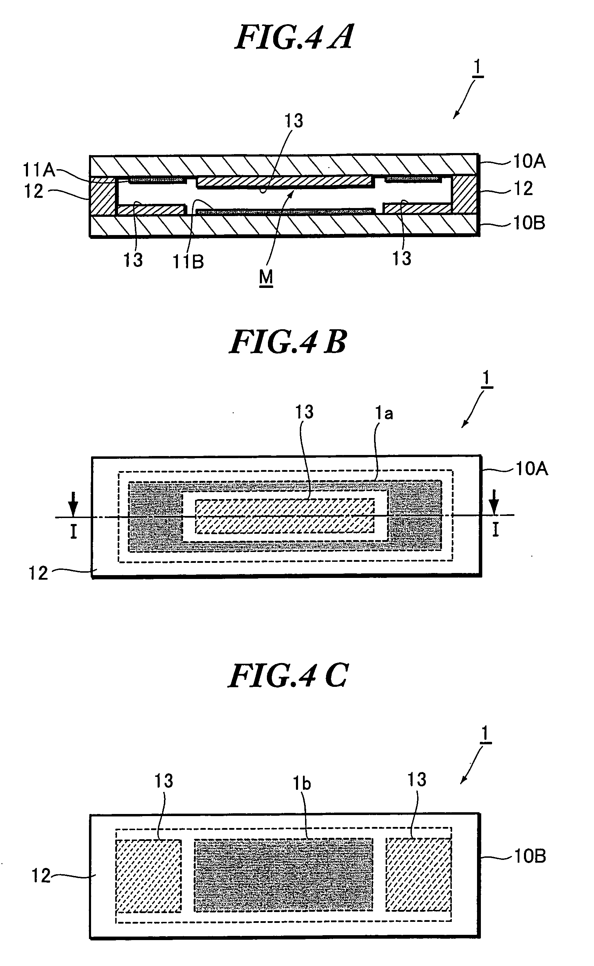

In the example shown in Figs. 4A to 4C, the position of the self-emitting element area 11A formed on one substrate 10A differs from that of the self-emitting element area 11B formed on the other substrate 10B. The self-emitting element area 11B on the other substrate 10B is provided so as to face the desiccant 13 provided at least on one substrate 10A.

Specifically, the self-emitting element area 11A is formed so as to form the annular display plane 1a on the side of the substrate 10A, whereas the self-emitting element area 11B is formed so that the display plane 1b is formed in the center on the side of the substrate 10B. The desiccant 13 is provided on the substrate 10B so as to face the self-emitting element area 11A, whereas another desiccant 13 is provided on the substrate 10A so as to face the self-emitting element area 11B.

According to the above-described embodiment, in addition to the effects described above, the effects produced by the desiccants 13 are directly applied on the self-emitting element areas 11A and 11B because the desiccants 13 are provided at the positions so as to face the self-emitting element areas 11A and 11B. Accordingly, the display performance of the self-emitting element areas 11A and 11B can be more surely maintained.

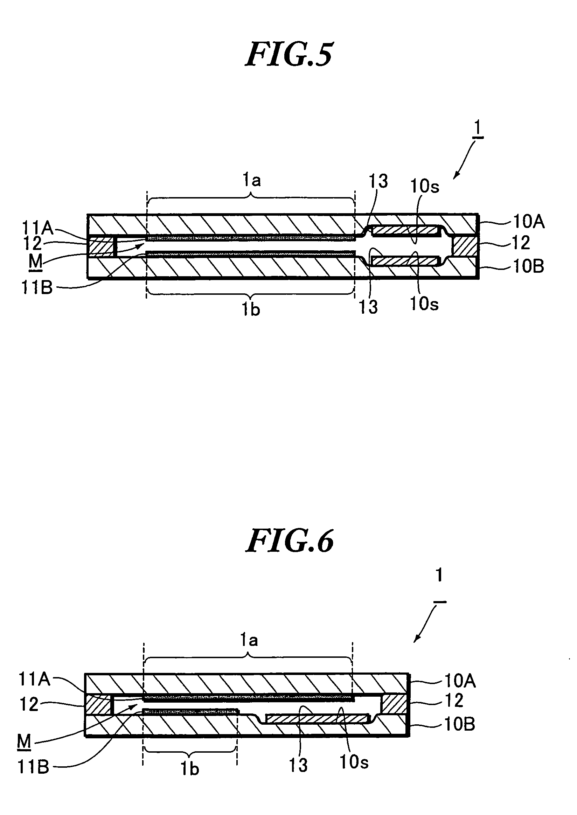

Figs. 5 and 6 are illustrative views (sectional views) showing a double-sided display device according to another embodiment of the present invention. In this embodiment, a concave engraved portion 10s is formed on the substrate 10A or 10B in the above-described embodiment so that the desiccant 13 is provided in the engraved portion 10s. The engraved portion 10s is formed on the substrate 10A or 10B by either one or both of etching and blasting.

A thickness of the desiccant 13 is generally considerably large with respect to the thickness of each of the self-emitting element areas 11A and 11B. According to the above-described structure, however, the desiccant 13 is provided in the concave engraved portion 10s, so that the substrate 10A and 10B can be bonded to each other with a reduced distance therebetween. Accordingly, the thickness of the entire double-sided display device 1 can be further reduced.

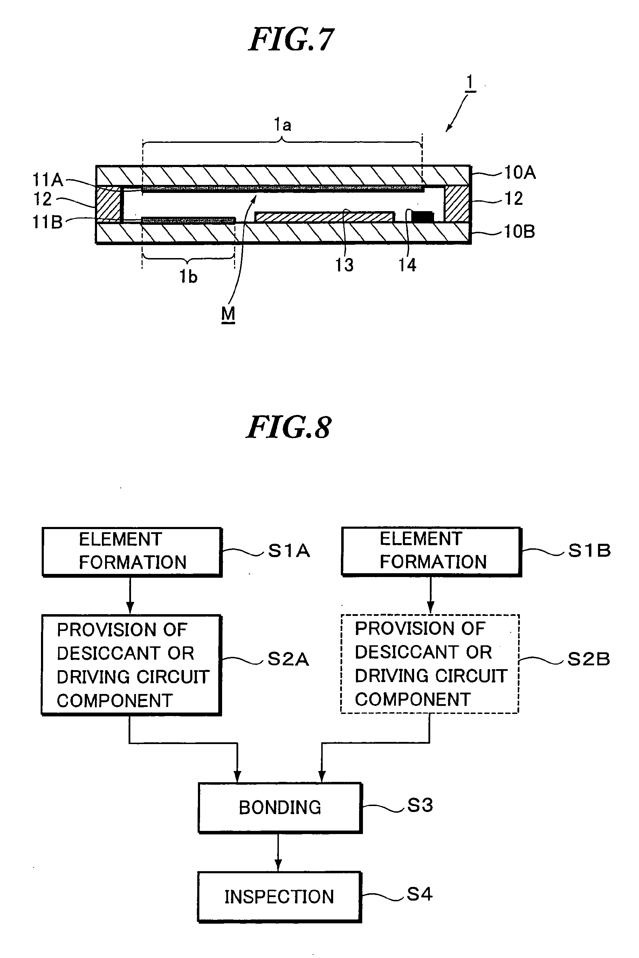

Fig. 7 is an explanatory view (sectional view) showing a double-sided display device according to a further embodiment of the present invention. In the double-sided display device 1 according to this embodiment, as in the above-described embodiment, the self-emitting element areas 11A and 11B are formed on the substrates 10A and 10B, respectively. The substrates 10A and 10B are bonded to each other to form the sealed space M therebetween. The self-emitting elements 11A and 11B are provided in the thus formed sealed space M. The display planes 1a and 1b are formed on the bottom face sides of the substrates 10A and 10B, respectively, so as to be oriented in the opposite directions. A driving circuit component 14 is provided in a space at least on one substrate 10B within the sealed space M.

Moreover, in this embodiment, the area of the self-emitting element area 11A formed on the substrate 10A differs from that of the self-emitting element area 11B formed on the other substrate 10B. The driving circuit component 14 is provided on the substrate 10B, on which the self-emitting element area 11B having the smaller area is formed.

In this embodiment, the driving circuit component (a semiconductor chip or the like), which is generally provided external to the sealed space M, is provided using a vacant space in the sealed space M. Accordingly, the space efficiency in terms of plane can be improved to achieve the reduction in the size of the display device. Moreover, since the driving circuit component 14 is provided in the sealed space M, this structure also serves to protect the driving circuit component 14. Therefore, since it is no longer necessary to separately form a sealed space for the driving circuit component 14, the space efficiency in the thickness direction can be improved. Moreover, if the desiccant 13 is similarly provided in a vacant space, the above-described effects can also be obtained.

Fig. 8 is an explanatory view showing a method of fabricating the double-sided display device according to the above-described embodiment. First, the self-emitting element areas 11A and 11B are formed on the substrates 10A and 10B, respectively (S1A and S1B). Thereafter, the desiccant 13 or the driving circuit component 14 is provided in the space on the surface of at least one substrate 10A (10B) on which the self-emitting element area 11A (11B) is formed (S2A and S2B). Then, the substrates 10A and 10B are bonded to each other (S3). At this step, the substrates 10A and 10B are bonded to each other so that the self-emitting element areas 11A and 11B face each other in such a manner that the self-emitting element areas 11A and 11B, the desiccant 13, the driving circuit 14, and the like are provide in the sealed space M formed by bonding the substrates 10A and 10B to each other. Thereafter, in the case where a plurality of panels are formed on the large substrates, the step of cutting the substrates into individual panels is added. After an inspection step (S4), which is conducted as needed, the double-sided display device 1 as a product is obtained.

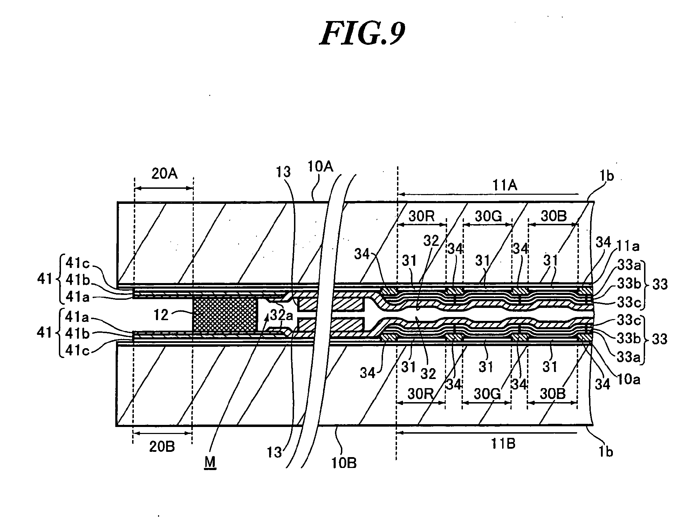

Fig. 9 is s an explanatory view (sectional view) showing an example of the present invention where organic EL elements are formed as the self-emitting element areas 11A and 11B (the same components as those in the above description are denoted by the same reference numerals, and the same description thereof is partially omitted).

In Fig. 9, the double-sided display device is obtained by bonding the substrates 10A and 10B to each other through the bonding layer 12 so that the self-emitting element areas 11A and 11B formed by organic EL elements are opposed to each other. The self-emitting element areas 11A and 11B are composed of a plurality of organic EL elements formed on the substrates 10A and 10B so as to interpose an organic material layer 33 including an organic light-emitting functional layer between a first electrode 31 and a second electrode 32. In the illustrated example, each of the organic EL elements has the following structure. A silicon coating layer 10a is formed on each of the substrates 10A and 10B. The first electrode 31 formed on the silicon coating layer 10a is used as an anode formed of a transparent electrode such as an ITO. Then, an insulating film 34 is formed on the first electrode 31 so that light-emitting areas 30R, 30G, and 30B are exposed through the insulating film 34. Then, in the light-emitting areas 30R, 30G, and 30B, a hole transport layer 33a, a light-emitting layer 33b and an electron transport layer 33c are deposited on the first electrode 31. Then, the second electrode 32 made of a metal material such as Al is formed thereon so as to be used as a cathode. Specifically, the organic EL elements are formed in the sealed space M formed by bonding the substrates 10A and 10B to each other through the bonding layer 12. In this manner, the organic EL elements are formed to have a bottom-emission structure, in which light is obtained through the substrates 10A and 10B.

In the sealed space M, an end 32a of the second electrode 32 is connected to a lead wiring 41. The lead wiring 41 is formed in a pattern while a second electrode layer 41c made of the same material and at the same fabrication step as those of the first electrode 31 is being insulated from the first electrode 31 by the insulating layer 34. On a led portion of the second electrode layer 41c, a first electrode layer 41b forming a low resistance wiring portion containing a silver-palladium (AgPd) alloy or the like is formed. On the first electrode layer 41b, a protective coating film 41a made of IZO or the like is formed as needed. The lead wirings 41 are put together in the ends of the substrates 10A and 10B, respectively, thereby forming the lead wiring sections 20A and 20B. Furthermore, the desiccants 13 are provided in the spaces on the substrates 10A and 10B within the sealed space M, respectively.

Although the self-emitting element areas 11A and 11B supposing a passive driving method are shown in this case, the driving method is not limited thereto. The self-emitting element areas 11A and 11B may be constituted to be driven by an active driving method.

It is preferred to use a flat plate-like or film-like substrate having transparency as each of the substrates 10A and 10B. The substrates 10A and 10B may be formed of glass, plastic or the like.

The combination of the hole transport layer 33a, the light-emitting layer 33b, and the electron transport layer 33c is generally used as the organic material layer 33, as descried above. However, the hole transport layer 33a, the light-emitting layer 33b, and the electron transport layer 33c may be provided in plural in number instead of providing only one layer for each. Either one or both of the hole transport layer 33a and the electron transport layer 33b may be omitted. An organic material layer such as a hole injection layer, an electron injection layer, and the like may be added in accordance with an intended application. A conventionally used material (may be a polymeric material or a low-molecular material) can be appropriately selected for the hole transport layer 33a, the light-emitting layer 33b, and the electron transport layer 33c.

Examples of the light-emitting material for forming the light-emitting layer 33b include any materials that emit light (produces fluorescence) when returning from a singlet excited state to a ground state and that emit light (produces phosphorescence) when returning from a triplet excited state through a singlet excited state to a ground state.

A thermally curable adhesive, a chemically curable (two-part mixture) adhesive, a photo (ultraviolet)-curable adhesive or the like can be used as an adhesive for forming the bonding layer 12. Examples of such a material include acrylic resins, epoxy resins, polyesters, polyolefins, and the like. In particular, the use of an ultraviolet-curable epoxy resin adhesive having high quick curability, which does not need a heat treatment, is preferred.

Examples of the desiccant 13 include a physical desiccant such as zeolite, a silica gel, carbon, and carbon nanotube, a chemical desiccant such as an alkali metal oxide, a metallic halide, and chlorine peroxide, a desiccant obtained by dissolving an organic metal complex in a petroleum solvent such as toluene, xylene, and an aliphatic organic solvent, and a desiccant obtained by dispersing desiccant particles in a binder such as polyethylene, polyisoprene, and polyvinyl cyanate, or the like. The desiccant 13 may be provided by adhering sheet-like desiccants onto the substrates 10A and 10B or by applying a resin containing a desiccating component onto the substrates 10A and 10B.

In this example, the self-emitting element areas 11A and 11B, each being formed of organic EL elements, may display a single color or a plurality of colors. In order to achieve multi-color display, it is apparent that an RGB selective deposition method can be used. Besides, a method using the combination of a monochromatic light-emitting functional layer such as white or blue and a color filter or a color changing layer made of a fluorescent material (a CF method or a CCM method), a method of radiating an electromagnetic wave on a light-emitting area of a monochromatic light-emitting functional layer or the like so as to achieve the light emission of a plurality of colors (a photobleaching method), a method of vertically depositing at least two unit display areas to form a single unit display area (a SOLED (transparent Stacked OLED) method) and the like can be used.

According to the above embodiments or examples, the double-sided display device includes, the pair of substrates 10A and 10B, on which the self-emitting element areas 11A and 11B are respectively formed, are bonded to each other so that their faces carrying the self-emitting elements 11A and 11B face each other. The display planes 1a and 1b are formed on the bottom face sides of the substrates 10A and 10B, respectively, so as to be oriented in the opposite directions. Since the sealed space M can be effectively used, the reduction in the size of the double-sided display device can be achieved. The outgas entering the sealed space M upon or after bonding of the substrates 10A and 10B can be effectively eliminated.

## Claims

1. A double-sided display device(1) comprising:
a pair of substrates(10A,10B);
self-emitting element areas(11A,11B) formed on the pair of substrates, respectively, the self-emitting element areas being provided in a sealed space (M) formed by bonding the pair of substrates to each other; and
display planes(1a,1b) each being formed on each bottom face of the substrates so as to be oriented in opposite directions, wherein
a desiccant(13) is provided in a space on at least one of the substrates within the sealed space.

2. The double-sided display device according to claim 1, wherein:
an area of the self-emitting element area formed on one of the pair of substrates differs from an area of the self-emitting element area formed on the other substrate; and
the desiccant is provided on the substrate including the self-emitting element area having the smaller area.

3. The double-sided display device according to claim 1, wherein
a position of the self-emitting element area formed on one of the pair of substrates is not coincident with a position of the self-emitting element area formed on the other substrate, and
the self-emitting element area on the other substrate is provided so as to face the desiccant provided on the one of the substrates.

4. The double-sided display device according to any one of claims 1 to 3, wherein
the desiccant is provided in an engraved portion(10s) formed on the substrate.

5. A double-sided display device(1) comprising:
a pair of substrates(10A,10B);
self-emitting element areas (11A, 11B) formed on the pair of substrates, respectively, the self-emitting element areas being provided in a sealed space (M) formed by bonding the pair of substrates to each other; and
display planes(1a,1b) each being formed on each bottom face of the substrates so as to be oriented in opposite directions, wherein
a driving circuit component(14) is provided in a space on at least one of the substrates within the sealed space.

6. The double-sided display device according to claim 5, wherein
an area of the self-emitting element area formed on one of the pair of substrates differs from an area of the self-emitting element area formed on the other substrate, and
the driving circuit component is provided on the substrate including the self-emitting element area having the smaller area.

7. A method of fabricating a double-sided display device(1) including: a pair of substrates(10A,10B); self-emitting element areas(11A,11B) formed on the pair of substrates, respectively, the self-emitting elements being provided in a sealed space(M) formed by bonding the pair of substrates to each other; and display planes(1a,1b) each being formed on each bottom face of the substrates so as to be oriented in opposite directions, the method comprising the steps of:
providing any one of a desiccant(13) and a driving circuit component(14) in a space on a face of at least one of the substrates, on which the self-emitting element area is formed, after formation of the self-emitting element areas on the respective substrates; and
arranging the one of the desiccant and the driving circuit component in the sealed space formed by bonding the pair of substrates to each other.
